# EUROPÄISCHE PATENTANMELDUNG

(11) **EP 2 947 687 A2**
(43) Veröffentlichungstag der Anmeldung: **25.11.2015**
(21) Anmeldenummer: 15168007.1
(22) Anmeldetag: 18.05.2015
(51) Int. Cl.: H01L 23/373, H01L 23/15

(54) **LEISTUNGSHALBLEITERMODUL**

(30) Priorität: 19.05.2014 DE 102014007351; 22.05.2014 DE 102014107217
(71) Anmelder: Powersem GmbH, 91126 Schwabach (DE); CeramTec GmbH, 73207 Plochingen (DE)
(72) Erfinder: Chadda, Ashok, 91126 Schwabach (DE); Dr. Kluge, Claus Peter, 95195 Röslau (DE)
(74) Vertreter: Neymeyr, Ulrich Theodor Paul

(57) **Zusammenfassung**

Ein Halbleitermodul 10 umfasst ein Wärmeableitelement aus einem nicht elektrisch leitfähigen Material, bevorzugt aus einem keramischen Material. Dabei ist eine Leiterbahnstruktur (24) auf dem Wärmeableitelement (30) aufgebracht und zumindest ein Halbleiterbauelement (26) ist an der Leiterbahnstruktur (24) befestigt und/oder über die Leiterbahnstruktur (24) elektrisch kontaktiert.

## Beschreibung

Die Erfindung betrifft ein Halbleitermodul gemäß dem Oberbegriff des Anspruchs 1 und ein Verfahren zur Herstellung eines Halbleitermoduls.

Halbleitermodule sind elektronische Bauelemente, die bevorzugt eine elektrische/elektronische Schaltfunktion, wie das Unterbrechen, Verbinden oder das Verstärken von Strömen und Spannungen umfassen. Hier werden bevorzugt elektronische/elektrische Leistungshalbleitermodule betrachtet, die bei dem Betrieb eine nennenswerte Menge an Verlustwärme verursachen. Zudem ist für derartige Halbleitermodule typisch, dass eine große Strommenge zu- und abgeleitet werden muss, so dass die elektrischen Bahnen (Leiterbahnen oder Wirebondings) einen ausreichenden Querschnitt aufweisen müssen. Da Leistungs-LED ähnliche Eigenschaften haben, werden sie auch als ein entsprechendes Halbleitermodul angesehen. Aus DE 10 2012 219 904 A1 ist bekannt, dass eine Leiterplatte aus AlN mit einer Leiterbahn beschichtet werden kann.

Bei dem Bau von Halbleitermodulen wird üblicherweise eine Platine (DCB = direct copper bond-board) verwendet, auf die das oder die Halbleiterelement(e) aufgebracht werden. Zudem müssen Strukturen bereitgestellt werden, wie z.B. ein Wärmeableitelement oder eine Heatsink, um die frei gewordene Wärme abzuleiten. Hierbei ist zum einen die große Anzahl der benötigten Komponenten nachteilig, da sie entsprechende Kosten verursacht. Auch erscheint die bekannte Ableitung der Wärme von dem Halbleiterbauelement über die Platine zu dem Wärmeableitelement nicht optimal.

Die Aufgabe der vorliegenden Erfindung ist somit, ein neues Halbleitermodul bereitzustellen, bei dem in einer kosten- und materialsparenden Bauweise die Wärmeableitung verbessert wird und das im industriellen Maßstab reproduzierbar und qualitativ hochwertig herstellbar ist.

Diese Aufgabe wird durch die Merkmale des unabhängigen Ansprüchs gelöst. Bevorzugte Weiterbildungen ergeben sich aus den abhängigen Ansprüchen.

Ein Halbleitermodul umfasst ein Wärmeableitelement, insbesondere eine Heatsink, aus einem nicht-elektrisch leitfähigen Material, bevorzugt aus einem keramischen Material. Dabei ist eine Leiterbahnstruktur auf dem Wärmeableitelement aufgebracht und zumindest ein Halbleiterbauelement ist an der Leiterbahnstruktur befestigt und/oder über die Leiterbahnstruktur elektrisch kontaktiert. Die Leiterbahnstruktur kann auch flächig ausgeführt sein. Die Leiterbahnstruktur ist somit bevorzugt untrennbar auf dem Wärmeableitelement aufgebracht. Hierdurch fällt die Verwendung von einer getrennten Leiterplatte weg, auf der die Halbleiterbauelemente befestigt sind und die mit dem Kühlkörper/Wärmeableitelement wärmeleitend gekoppelt werden muss. Dies spart zum einen Kosten und zudem wird die Wärmeableitung deutlich verbessert.

Bevorzugt ist zumindest ein Kontaktpin zur elektrischen Kontaktierung des Halbleitermoduls mit der Leiterbahnstruktur verbunden. Die Verbindung kann eine Lötung sein. Der Kontaktpin wird aus einem Gehäuse des Halbleitermoduls herausgeführt und kann bevorzugt eine Lötfahne oder ein Löt- oder Einpresspin umfassen.

Insbesondere umfasst das Wärmeableitelement an zumindest zwei gegenüberliegenden Seiten einstückig Flanken, wobei das zumindest eine Halbleiterbauelemente sich innerhalb des von den Flanken aufgespannten Volumens befindet. So wird an der Unterseite des Halbleitermoduls, also an der Seite, die von den Kühlrippen oder Kühlstreben oder -stiften entfernt ist, ein Verbindungsbereich zum Verbinden mit einer Umgebungsstruktur geschaffen. Der Verbindungsbereich dient zur mechanischen Lagerung, wie auch dem Temperaturfluss von dem Halbleitermodul an die Umgebungsstruktur.

Alternativ oder zusätzlich kann das Wärmeableitelement von einer Basisfläche ausgehend, die als Träger der Leiterbahnen und/oder des zumindest einen Halbleiterbauelements dient, Flanken aufweisen, die umlaufend geschlossen ein Volumen aufspannen, innerhalb dessen das zumindest eine Halbleiterbauelement sich befindet. Hierdurch wird ein Bereich in der Art einer Gussform geschaffen. Dieser Bereich kann zum Schutz der Halbleiterbauelemente und/oder des Bondings mit einer Füll- oder vergussmasse gefüllt werden, ohne dass hierfür weitere Komponenten benötigt würden.

Bevorzugt umfassen die Flanken zumindest einen nach außen abgewinkelten Flansch, der bevorzugt an ihren freien Enden oder an ihren der Basisfläche entfernten Enden vorgesehen ist. Der Flansch ist bevorzugt einstückig Bestandteil des Wärmeableitelements. Dieser Flansch dient als Auflager gegenüber der Umgebungsstruktur und zudem als Kontaktflächenvergrößerung zur Verbesserung des Wärmeflusses.

Insbesondere umfasst der zumindest eine Flansch einen Montagebereich, insbesondere eine Bohrung, zur Befestigung des Halbleitermoduls an einer Umgebungsstruktur. Da das Wärmeableitelement bevorzugt als ein Sinterteil ausgeführt ist, kann man hierüber einfach einen entsprechenden Montagebereich formen. Bevorzugt sind die Leiterbahnen auf einer weitgehend ebenen und/oder absatzfreien Fläche des Wärmeableitelements aufgebracht.

Bevorzugt umfasst das Wärmeableitelement zumindest eine bahnartige Vertiefung, deren Breite an die Breite der Leiterbahnen angepasst ist und die Leiterbahnen erstrecken sich zumindest teilweise innerhalb der bahnartigen Vertiefungen. Die bahnartige Vertiefung oder Vertiefungen können auch eine flächige Ausdehnung annehmen, so dass ein Großteil der Basisfläche vertieft ist und in diesem Fall dienen unabgesenkte Stege als Bereiche der Isolation. Die Breite der bahnartigen Vertiefungen ist bevorzugt identisch zu der Breite der dort angeordneten Leiterbahn. Die Vertiefung(en) sind kostengünstig herstellbar, da in die Sinterform des Wärmeableitelements Erhöhungen integriert sein können, die den Vertiefungen entsprechen und die somit praktisch ohne Mehrkosten hergestellt werden können.

Insbesondere kann die Dicke der Leiterbahn im Bereich von 40% bis 200% der Tiefe der bahnartigen Vertiefungen liegen und bevorzugt im Bereich von 80% bis 150% der Tiefe der bahnartigen Vertiefungen. Wenn die bahnartigen Vertiefungen nicht komplett mit den Leiterbahnen gefüllt sind, so kann der Restbetrag mit dem Lötmaterial aufgefüllt werden. Dies hat den Vorteil, dass die Halbleiterbauelemente möglichst nah an dem Wärmeableitelement angeordnet sein können, so dass der Wärmeabfluss unterstützt wird. Aufgrund der Vertiefungen kann bei dem Aushärten des aufgebrachten Leiterbahnmaterials eine höhere Temperatur verwendet werden, die sogar in Bereich des Schmelzpunkts kommen kann, ohne dass das Material verlaufen würde.

Vorteilhafterweise ist das Wärmeableitelement einstückig und besteht bevorzugt einstückig aus einem homogenen Material. Die Leiterbahnstruktur ist entweder unmittelbar auf das Wärmeableitelement aufgebracht oder zwischen der Leiterbahnstruktur und dem Wärmeableitelement liegt zumindest eine Mittlerschicht, wobei die Summe der Dicken der zumindest einen Mittlerschicht weniger als 100 µm beträgt. Dies bedeutet insbesondere, dass zwischen der Leiterbahnstruktur und dem Wärmeableitelement eine oder mehrere dünne Schichten, wie z.B. ein Haftgrund zur Verbesserung der Verbindung der Schichten liegen kann.

Bei einem Verfahren der Herstellung eines Halbleitermoduls, wird in einem Sinterverfahren ein Wärmeableitelement hergestellt. Dabei umfasst das Wärmeableitelement eine Negativform einer Leiterbahnstruktur. Anschließend wird eine metallische Struktur, insbesondere eine Kupferlegierung, in die Negativform zumindest teilweise füllend eingebracht und mit dem Wärmeableitelement wird zur Bildung einer Leiterbahnstruktur verbunden wird und nachfolgend zumindest ein Halbleiterbauelement mit der Leiterbahnstruktur kontaktiert, insbesondere verlötet.

Im Folgenden wird die Erfindung anhand schematischer Zeichnungen an Ausführungsbeispielen näher erläutert. Es zeigt:
- Fig. 1: einen Schnitt durch ein Leistungshalbleitermodul nach dem Stand der Technik,
- Fig. 2: einen Schnitt durch ein leiterplattenfrei Leistungshalbleitermodul mit Löt- oder Einpresspins
- Fig. 3: eine alternative Ausführungsform mit Lötfahnen,
- Fig. 4: eine weitere alternative Ausführungsform des Wärmeableitelements,
- Fig. 5: eine perspektivische Ansicht des Wärmeableitelements gemäß Fig. 4,
- Fig. 6: eine perspektivische Ansicht einer alternativen Ausführungsform des Wärmeableitelements,
- Fig. 7: eine weitere alternative Ausführungsform des Wärmeableitelements im Schnitt und
- Fig. 8: das Detail X der Fig. 6.

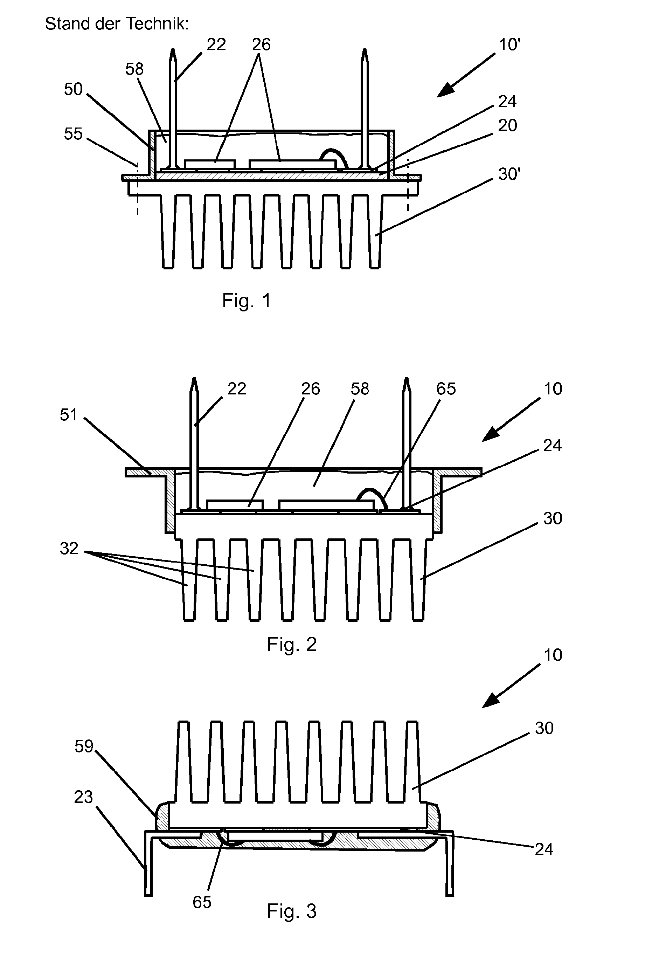

In Fig. 1 wird ein aus dem Stand der Technik bekanntes Halbleitermodul 10' gezeigt. Auf einer Leiterplatte 20 ist eine Mehrzahl von Leitern 24 aufgebracht. Diese Leiterplatte 20 wird auch als DCB (Direct-Copper-Bonding)-Element bezeichnet. Ferner sind zwei Halbleiterbauelemente 26 gezeigt, die mit den Leitern 24 elektrisch verbunden, bevorzugt verlötet sind. Zudem sind an den Leitern 24 Löt- oder Einpresspins 22 angebracht, die der elektrischen Verbindung des Halbleitermoduls 10' dienen. Bei der Herstellung des Halbleitermoduls wurde ein Gußrahmen 50 um die Leiterplatte 20 gesteckt und der innerhalb des Rahmens befindliche Raum mit einer Füllmasse 58 gefüllt, um so die Halbleiterbauelemente 26 vor schädlichen Umgebungseinflüssen zu schützen. Das so hergestellte Halbleitermodul 10' lässt sich über eine Verschraubung 55 mit einem Wärmeableitelement oder Kühlkörper 30' verbinden. Das Wärmeableitelement 30' wird nachfolgend auch als Heatsink 30 bezeichnet.

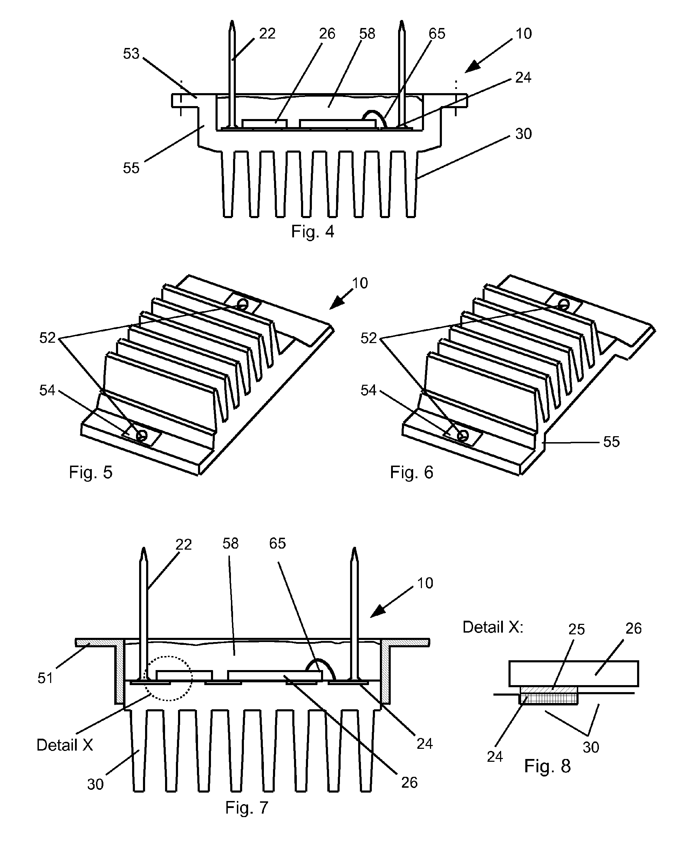

Fig. 2 zeigt eine Ausführungsform, bei der keine Leiterplatte innerhalb des Halbleitermoduls 10 verwendet wird. Statt dessen sind die Leiterbahnen 24 unmittelbar und untrennbar auf das Wärmeableitelement 30 aufgebracht. Die Leiterbahnen 24 dienen zunächst als mechanische Träger für die Halbleiterbauelemente 26. Diese Verbindung ist bevorzugt eine Verlötung. Zudem dienen die Leiterbahnen 24 zur elektrischen Kontaktierung der Halbleiterbauelemente 26. Neben der Verlötung kann für die Kontaktierung ein Wirebonding 65 verwendet werden. Zudem sind Löt- und/oder Einpresspins 22 mit den Leiterbahnen verbunden und aus dem Halbleitermodul 10 herausgeführt, um so das Halbleitermodul 10 elektrisch kontaktieren zu können. Bei der Herstellung des Halbleitermoduls 10 wird nach dem Aufbringen der elektrischen Komponenten 22, 24, 26 und 65 ein Gußrahmen 51 über den Außenbereich des Wärmeableitelements 30 gezogen und anschließend wird der Bereich der elektrischen Komponenten umgossen. Der Gußrahmen ist ein Spritzgussteil, das gesondert hergestellt wurde und kann an einem umlaufenden Flansch Bohrungen zur Verschraubung des Halbleitermoduls 10 aufweisen. Auf der Seite des Wärmeableitelements 30, die dem Bereich der Halbleiterbauelemente 26 gegenüber liegt, ist eine Mehrzahl von Kühlrippen 32 angeordnet. Wie es in Fig. 5 oder 6 perspektivisch gezeigt ist, können die Kühlrippen 32 einstückig an das Wärmeableitelement 30 angeformte parallele platten- oder stegförmige Elemente sein, die senkrecht von dem Grundkörper des Wärmeableitelements 30 weg weisen. Alternativ und/oder zusätzlich können stiftartige Elemente verwendet werden, die sich igelartig von dem Grundkörper in eine oder mehrere Richtungen erstrecken. Prinzipiell kann das Wärmeableitelement jede beliebige Form aufweisen, die eine Kühlkonvektion unterstützt.

Das Wärmeableitelement 30 kann auch in den Gussrahmen 51 eingeklemmt sein. Der Gussrahmen kann auch als Gehäuse für das Wärmeableitelement 30 dienen.

Alternativ zu der oben genannten Verlötung des zumindest einen Halbleiterelements 26 kann dieses unmittelbar, also ohne eine dazwischenliegende Leiterbahn, an dem Wärmeableitelement 30 befestigt, wie bevorzugt verklebt sein. In diesem Fall wird das Halbleiterelement 26 über ein Wirebonding 65 mit der Leiterbahnstruktur 24 verbunden. Auch Kombinationen der Verlötung des Halbleiterelements 26 zusammen mit einem Wirebonding 65 sind möglich.

Die Ausführungsform der Fig. 3 ähnelt der Ausführungsform gemäß Fig. 2, wobei aber die Löt- oder Einpresspins 22 gegen Lötfahnen 23 ausgetauscht sind, die als Metallblech flach mit entsprechenden Abschnitten der Leiterbahnen 24 verbunden sind und seitlich abgeleitet werden. Diese Baugruppe wird in einen Spritzgussverfahren umspritzt und die Lötfahnen 23 werden zur Befestigung an z.B. einer Platine (nicht dargestellt) abgewinkelt.

Fig. 4 zeigt eine weitere alternative Ausführungsform. Hierbei sind die Leiterbahnen 24 und Halbleiterbauelemente 26 entlang einer Basisfläche des Wärmeableitelements 30 angeordnet. Die Basisfläche muss nicht notwendigerweise eben sein. Die Basisfläche kann rechteckförmig sein. An den Rändern der Basisfläche erstreckt sich zu allen Seiten umlaufend geschlossen eine Flanke 55. Die Flanke hat eine Höhe von mindestens 3 mm und bevorzugt bis zu 15 mm. Die maximale Erhebung der Halbleiterbauelemente 26 und der Wirebonding 65 ist geringer, als die Höhe der Flanken 55. Zwischen den Flanken ergibt sich ein Volumen, das so mit einer Füll- oder Vergussmasse 58 gefüllt ist, dass die genannten Komponenten komplett bedeckt und entsprechend geschützt sind. In diesem Sinne dienen die Innenseiten der Flanken 55 als eine Art Gußform zur Aufnahme der Füllmasse 58. Die Stirnseiten der Flanken 55 dienen als Auflagefläche für das Wärmeableitelement auf z.B. einem Gehäuse oder einer Rahmenstruktur eines Umgebungsteils. Zur Befestigung kann ein Flansch 53 vorgesehen sein. Bei dieser Bauweise wird somit nicht nur an den Kühlrippen 32 die Wärme über Konvektion an die Umgebung abgegeben, sondern es besteht auch ein Wärmefluss innerhalb des Materials von der Basisfläche über die Flanke 55 an das genannte Umgebungsteil. So wird die Temperaturerhöhung effektiv begrenzt.

Bei der in Fig. 4 und 5 gezeigten Ausführungsform sind die Flanken 55 an allen vier Seiten der Basisfläche vorgesehen. Alternativ können die genannten Flanken auch nur teilweise vorgesehen sein. So zeigt Fig. 5 eine Ausführungsform, bei der nur an zwei Seiten eine Flanke 55 vorgesehen ist. Diese Form eignet sich für die Herstellung des Wärmeableitelements 30 im Verfahren der Extrusion, da das Wärmeableitelement 30 ein gleichbleibendes Querschnittsprofil aufweist. In Fig. 5 und 6 sind zudem Bohrungen 52 gezeigt, über die das Halbleitermodul 10 mit der Umgebungsstruktur verbunden werden kann. Zudem ist im Umfeld der Bohrungen 52 ein metallischer Bereich 54 aufgebracht. Dieser Bereich 54 kann aus dem gleichen (Kupfer-)Metall wie die Leiterbahnen 24 gefertigt sein. Er dient wie eine Unterlegescheibe dem Zweck, dass eine Verschraubung gegen ein unbeabsichtigtes Lösen gesichert wird. Die Dicke dieser Schicht kann bevorzugt 100 bis 500µm betragen.

Figuren 7 und 8 zeigen eine weitere alternative Ausführungsform. Bei den vorstehend beschriebenen Ausführungsformen hatte das Wärmeableitelement 30 in dem Bereich, in dem das oder die Halbleiterbauelement(e) 26 aufgebracht sind, eine weitgehend ebene Fläche. Diese Fläche (=Basisfläche) hat eine gewisse Rauigkeit, um die Verbindung mit der Leiterbahnstruktur 24 zu verbessern. Fig. 7 zeigt die Veränderung, dass die Leiterbahnstruktur 24 in die Oberfläche des Wärmeableitelements 30 eingebettet ist. Bei der Herstellung des Wärmeableitelements 30 wurden die entsprechenden Vertiefungen, oder Kanäle angeformt, die nachfolgend mit dem Material der Leiterbahn gefüllt wurden. Die Vertiefungen können eine Tiefe von 300µm bis bevorzugt 1 mm betragen. Dieser Aufbau ist im Detail der Fig. 8 vergrößert gezeigt. Bei dieser Ausführungsform ist die Oberseite der Leiterbahn 24 bündig mit der benachbarten Oberfläche des Wärmeableitelements 30. Oberhalb der Leiterbahnstruktur 24 ist ein Lötmittel 25 gezeigt über das das Halbleiterbauelement 26 kontaktiert wird. Hieraus ergibt sich das der Abstand von dem Halbleiterbauelement an Stellen, wo keine Verlötung vorgesehen ist, der Dicke der Lötschicht 25 entspricht. Bei alternativen Ausführungsformen muss die in das Wärmeableitelement 30 eingeformte Negativform der Leiterbahnen nicht komplett mit dem Material der Leiterbahn gefüllt sein. Hierdurch ergibt sich (bei gleicher Dicke der Lötschicht 25) ein geringer Abstand der Unterseite des Halbleiterbauelements 26 zu der entsprechenden Oberfläche des Wärmeableitelements 30, was die Wärmeableitung verbessert. Dieser Abstand kann mit einem Wärmeleitmittel gefüllt sein. Alternativ kann die genannte Negativform zu über 100% gefüllt sein, so dass die Oberseite der Leiterbahn 24 sich oberhalb der Basisfläche erstreckt.

Das Aufbringen des Kupfers kann bei allen Ausführungsformen unter Verwendung einer Kupferpaste geschehen. Diese kann CuO oder Cu₂O umfassen. Zudem kann ein Haftverbesserungsmittel zugesetzt sein. Wenn die Keramik AlN (Aluminiumnitrit) ist, eignet sich als Haftverbesserungsmittel ZnO-SiO₂. Die Kupferpaste wird bevorzugt aufgespritzt. Auch eignet sich das Verfahren des Pastendrucks. Bei herkömmlichen Druckverfahren waren Druckdicken von bis zu ca. 500 µm möglich. Anschließend wird herkömmlich bedruckte Struktur in einem Einbrennofen bei ca. 900°C unter Stickstoffumgebung und bei möglichst geringem Sauerstoffanteil ausgehärtet. Sofern eine größere Druckdicke gewünscht wird, so musste herkömmlich dieser Druck- und Aushärtevorgang wiederholt werden. Das Problem beim Stand der Technik war nämlich, dass eine zu große gedruckte Dicke verlaufen würde und kein sauberes Druckbild entstehen lässt. Durch die oben beschriebene Negativform wird hingegen für das gedruckte Material eine Form geschaffen, innerhalb derer es sich ausbreiten kann. Aufgrund von Effekten der Oberflächenspannung tritt das noch flüssige (oder zähflüssige) Material auch dann nicht über den Rand der Negativform, wenn diese Form zu über 100% gefüllt ist. Auf diese Weise lässt sich in einem Druckvorgang eine größere Dicke von bspw. 1000 µm oder 1500 µm herstellen. Für Leistungselektronikbauteile sind Dicken von 400 µm bis 1500 µm besonders vorteilhaft. Eine große Dicke der Leiterbahnen ist zum einen bei Leistungselektronikbauteilen notwendig, da die übertragenen Ströme relativ groß sind. Zu anderen ist die Wärmeleitfähigkeit von Kupfer exzellent. Je größer die Dicke der Leiterbahn, desto größer wird der Wärmeflussquerschnitt und somit verbessert sich die Wärmeableitung von dem Halbleiterbauelement 26.

Auch kann zur Aufbringung der Leiterbahnstruktur ein Siebdruckverfahren verwendet werden. Nach dem Aufdrucken wird durch Sintern die aufgedruckte Leiterbahnstruktur innig mit dem Material des Wärmeableitelements 30 verbunden. Dadurch werden eingesinterte Leiterbahnstrukturen geschaffen, wodurch die von den Leistungshalbleitern im Betrieb entstehende Wärme direkt in das Material des Wärmeableitelements 30 eingeleitet wird. Ein Ausfall der Leistungshalbleiter oder anderer Bauteile, die mit der Leiterbahnstruktur elektrisch verbunden sind, aufgrund Überhitzung ist vermieden. Sind dicke Leiterbahnstruktur erforderlich, kann das Aufdrucken auch mehrfach vorgenommen werden. Entweder werden die Leiterbahnstrukturen auf den Grünkörper aufgebracht und anschließend wird dieser zusammen mit den Leiterbahnstrukturen gesintert, oder die Leiterbahnstrukturen werden auf das gesinterte Wärmeableitelement aufgedruckt und anschließend erfolgt ein weiteres Sintern, um versinterte Leiterbahnstrukturen zu schaffen.

Die Leiterbahnstrukturen können jedoch auch über DCB Verfahren (Direct Copper Bonding) oder AMB Verfahren (Active Metall Brazing) aufgebracht werden.

Als Material für das Wärmeableitelement 30 kommt ein nichtleitender Werkstoff, insbesondere ein keramischer Werkstoff, zum Einsatz. Beispielsweise können bevorzugt Aluminiumoxid (Al₂O₃), technisches Aluminumoxid, Aluminiumnitrid (AlN), Siliziumnitrid, Glaskeramik, LTCC, (Low Temperature Cofired Ceramics), Siliziumcarbid, Bornitrid Zirkonoxid oder Boroxid verwendet werden. Eine Dotierung kann bei sämtlichen Keramikwerkstoffen gegeben sein. Bevorzugt wird ein Werkstoff mit einer hohen Wärmeleiteigenschaft verwendet. Dies kann bevorzugt Aluminiumoxid sein, mit einer Wärmeleitfähigkeit von ca. 25 - 30 W/mK oder reine oder technisch reine Aluminiumnitrid-Keramiken mit Wärmeleitfähigkeiten von bis zu 200 W/mK.

Als Halbleiterbauelement 26 kommen bevorzugt Bauelemente zum Einsatz, die eine hohe Wärmeabstrahlung aufweisen. Dies können (Leistungs-)Dioden, Thyristoren, Transistoren, Halbleiterschalter bzw. -relays oder dergleichen sein. Auch kann das Halbleiterelement eine LED sein. Dies sind Anwendungen, bei denen relativ hohe Ströme durch die Leiterbahnen geführt werden, die deshalb einen großen Leiterquerschnitt aufweisen müssen. Auch geben die LED eine große Wärmemenge ab, die schnell an das Wärmeableitelement abgeleitet werden kann. Entsprechende LED-Leuchten werden insbesondere als Scheinwerfer oder Flutlichtanlage verwendet.

Die Füllmasse 58 kann eine Vergussmasse sein, die härtbar ist, wie z.B. eine Epoxydharzmasse oder eine Polyurethanmasse (PUR).

Merkmale unterschiedlicher Ausführungsformen sind frei miteinander kombinierbar, sofern keine konstruktiven Gründe dem zwingend entgegenstehen. Komponenten oder Bereiche unterschiedlicher beispielhafter Ausführungsformen der Erfindung werden mit dem gleichen Bezugszeichen bezeichnet, sofern ihre Funktion und Wirkungsweise gleich oder vergleichbar ist.

## Patentansprüche

1. Halbleitermodul (10), umfassend ein Wärmeableitelement (30) aus einem nicht elektrisch leitfähigen Material, bevorzugt aus einem keramischen Material,
**dadurch gekennzeichnet, dass**
eine Leiterbahnstruktur (24) auf dem Wärmeableitelement (30) aufgebracht ist und zumindest ein Halbleiterbauelement (26) an der Leiterbahnstruktur (24) befestigt und/oder über die Leiterbahnstruktur (24) elektrisch kontaktiert ist.

2. Halbleitermodul gemäß Anspruch 1, **dadurch gekennzeichnet, dass** zumindest ein Kontaktpin (22, 23) zur elektrischen Kontaktierung des Halbleitermoduls mit der Leiterbahnstruktur verbunden, wie insbesondere verlötet, ist und aus einem Gehäuse des Halbleitermoduls (10) herausgeführt ist.

3. Halbleitermodul gemäß einem der vorangegangenen Ansprüche, **dadurch gekennzeichnet, dass** das Wärmeableitelement (30) an zumindest zwei gegenüberliegenden Seiten einstückig Flanken (55) umfasst, wobei das zumindest eine Halbleiterbauelement (26) sich innerhalb des von den Flanken aufgespannten Volumens befindet.

4. Halbleitermodul gemäß einem der vorangegangenen Ansprüche, **dadurch gekennzeichnet, dass** das Wärmeableitelement (30) von einer Basisfläche ausgehend, die als Träger der Leiterbahnstruktur (24) und/oder des zumindest einen Halbleiterbauelements (26) dient, Flanken (55) aufweist, die umlaufend geschlossen ein Volumen aufspannen, innerhalb dessen das zumindest eine Halbleiterbauelement (26) sich befindet.

5. Halbleitermodul gemäß einem der Ansprüche 3 oder 4, **dadurch gekennzeichnet, dass** die Flanken (55) zumindest einen nach außen abgewinkelten Flansch (53) umfassen, der bevorzugt an ihren freien Enden oder an ihren der Basisfläche entfernten Enden vorgesehen ist.

6. Halbleitermodul gemäß Anspruch 5, **dadurch gekennzeichnet, dass** der zumindest eine Flansch (53) einen Montagebereich, insbesondere eine Bohrung (52) zur Befestigung des Halbleitermoduls an einer Umgebungsstruktur umfasst.

7. Halbleitermodul gemäß einem der Ansprüche 1 bis 5, **dadurch gekennzeichnet, dass** das Wärmeableitelement (30) zumindest eine bahnartige Vertiefung umfasst, deren Breite zumindest bereichsweise an die Breite der Leiterbahnen (24) angepasst ist und die Leiterbahnen sich zumindest teilweise innerhalb der bahnartigen Vertiefungen erstrecken.

8. Halbleitermodul gemäß Anspruch 7, **dadurch gekennzeichnet, dass** die Dicke der Leiterbahn (24) im Bereich von 40% bis 200% der Tiefe der bahnartigen Vertiefungen liegt und bevorzugt im Bereich von 80% bis 150% der Tiefe der bahnartigen Vertiefungen liegt.

9. Halbleitermodul gemäß einem der vorangegangenen Ansprüche, **dadurch gekennzeichnet, dass** das Wärmeableitelement (30) einstückig ist und bevorzugt einstückig aus einem homogenen Material besteht und dass die Leiterbahnstruktur (26) entweder unmittelbar auf das Wärmeableitelement (30) aufgebracht ist oder das zwischen der Leiterbahnstruktur (26) und dem Wärmeableitelement (30) zumindest eine Mittlerschicht liegt, wobei die Summe der Dicken der zumindest einen Mittlerschicht weniger als 100 µm beträgt.

10. Verfahren der Herstellung eines Halbleitermoduls, wobei in einem Sinterverfahren ein Wärmeableitelement (30) hergestellt wird und das Wärmeableitelement (30) eine Negativform einer Leiterbahnstruktur (24) umfasst, wobei anschließend eine metallische Struktur, insbesondere eine Kupferlegierung, in die Negativform zumindest teilweise füllend eingebracht und zur Bildung einer Leiterbahnstruktur (24) ausgehärtet wird und nachfolgend zumindest ein Halbleiterbauelement (26) mit der Leiterbahnstruktur kontaktiert, insbesondere verlötet, wird.
